# EUROPEAN PATENT SPECIFICATION

(11) **EP 2 519 982 B1**
(45) Date of publication and mention of the grant of the patent: **21.03.2018**
(21) Application number: 10840425.2
(22) Date of filing: 08.10.2010
(51) Int. Cl.: H01L 33/00, H01L 33/44, H01L 33/12, H01L 21/02, H01L 33/32

(54) **EPITAXIAL WAFER, METHOD FOR MANUFACTURING THE SAME AND METHOD FOR MANUFACTURING LED CHIP**
EPITAXIALWAFER, VERFAHREN ZU DESSEN HERSTELLUNG UND VERFAHREN ZUR HERSTELLUNG EINES LED-CHIPS
PLAQUETTE ÉPITAXIALE, SON PROCÉDÉ DE FABRICATION ET PROCÉDÉ DE FABRICATION D'UNE PUCE À DEL

(30) Priority: 29.12.2009 CN 200910258858
(43) Date of publication of application: 07.11.2012
(73) Proprietor: Shenzhen BYD Auto R&D Company Limited, Shenzhen, Guangdong 518118 (CN); BYD Company Limited, Shenzhen, Guangdong 518118 (CN)
(72) Inventor: ZHANG, Wang, Shenzhen, Guangdong 518118 (CN); SU, Xilin, Shenzhen, Guangdong 518118 (CN); XIE, Chunlin, Shenzhen, Guangdong 518118 (CN); HU, Hongpo, Shenzhen, Guangdong 518118 (CN)
(74) Representative: Gulde & Partner
(86) International application number: PCT/CN2010/077604
(87) International publication number: WO 2011/079636

(56) References cited:
- EP-A1- 0 507 420
- WO-A2-2007/002644
- CN-A- 1 881 625
- JP-A- H01 125 917
- JP-A- 2004 014 587
- JP-A- 2005 116 785
- JP-A- 2009 190 965
- US-A1- 2003 173 578
- US-A1- 2006 051 938
- US-A1- 2007 172 973
- US-A1- 2007 254 390
- US-A1- 2009 179 211

## Description

The present disclosure generally relates to semiconductor field, more particularly, to a method for manufacturing an epitaxial wafer for a light emitting diode (LED), an epitaxial wafer using the same, and a method for manufacturing a LED chip.

### BACKGROUND

Because a light emitting diode has advantages of long life and high energy utilization rate, it becomes a new light source to replace the conventional light source. For the light emitting diode, the color of the light corresponds to the frequency of the light, i.e., to a band gap of the semiconductor material. InGaN is an ideal material for a light emitting layer in a LED of blue light, green light or purple light. The band gap of GaN is about 3.4 eV, and may be modulated from about 0.7 eV to about 3.4 eV by doping indium.

The epitaxial wafer for the LED comprises a buffer layer, an N type semiconductor layer, a multi-quantum well layer and a P type semiconductor layer which are grown in turn. The N type and P type semiconductor layers are formed from III-V group compounds, such as GaN or GaAs. A GaN light emitting diode is described for illustration purpose in this specification.

Conventionally, an epitaxial wafer for a light emitting diode is manufactured in a metal organic chemical vapor deposition (MOCVD) device. The method for manufacturing the epitaxial wafer comprises the steps of: growing a buffer layer on a top surface of a sapphire substrate through epitaxial technology; growing an N type GaN layer on the buffer layer through epitaxial technology; growing a multi-quantum well layer on the N type GaN layer; and growing a P type semiconductor layer on the multi-quantum well layer.

It should be noted that a wavelength of a LED light is determined by a content of indium in the multi-quantum well layer. For the multi-quantum well layer containing about 13% indium, the growth temperature is generally about 750°C. The indium content is very sensitive to the temperature. When the temperature is changed by about 1 K, the indium content will be changed by about 0.3%, and the emission wavelength will be changed by about 1.5 nm. The MOCVD device is bottom heated, so the temperature gradient distribution from bottom to top in the cavity of the MOCVD device may be formed. The temperature becomes lower from the lower part to the upper part of the cavity, hence there is a 2K temperature difference between the top surface and the lower surface of the sapphire substrate. Due to the temperature difference, the lower surface of the substrate with higher temperature may have a larger thermal expansion, and consequently the substrate will warp upwards and the shape of the substrate will be changed to a bowl shape from a plate shape. Due to the presence of the temperature gradient, the warped epitaxial wafer may have a height difference of about 10 µm and a temperature difference of about 7 K between the center and edges thereof. Therefore, in the bottom heated MOCVD device, the wavelength of the light emitting from the center and the edge of the epitaxial layer have a difference of 1.5 × 7=10.5 nm. In other words, the LED chip comprising the epitaxial wafer may have a bad light uniformity. Therefore, during manufacturing of the LED chip, after grinding, polishing, dicing and chipping, point measurement and separation are needed to obtain the LED chips with different wavelengths, which may increase the manufacturing processes and cost related thereto.

US 2007/0254390 A1 discloses a method of preparing a nitride optoelectronic device including the step of simultaneously forming two n-type III-N layers over opposite sides of a substrate.

JP 2005-116785 A provides a method for growing a semiconductor material thin film which reduces an amount of warping of a substrate. Therefore a rear surface of a sapphire substrate is coated in advance with GaN or AlN₄. The upper surface is coated with GaN2 by an metal vapor growing method. Thereafter, AlGaN is grown on the upper surface.

### SUMMARY

The present disclosure is directed to solve at least one of the problems existing in the prior art. Accordingly, a method for manufacturing an epitaxial wafer for a light emitting diode (LED), an epitaxial wafer using the same, and a method for manufacturing a LED chip are provided, in which the LED chip may have an increased light uniformity.

According to an aspect of the present disclosure, a method for manufacturing an epitaxial wafer for a light emitting diode (LED) as defined in claim 1 is provided.

According to another aspect of the present disclosure, an epitaxial wafer for a light emitting diode as defined in claim 3 is provided.

According to still another aspect of the present disclosure, a method for manufacturing a LED chip as defined in claim 6 is provided.

Additional aspects and advantages of the embodiments of the present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of the disclosure will become apparent and more readily appreciated from the following descriptions taken in conjunction with the drawings in which:
Fig. 1 is a schematic flow chart of a method for manufacturing an epitaxial wafer for a light emitting diode according to an embodiment of the present disclosure;
Fig. 2 is a cross sectional view of an epitaxial wafer for a light emitting diode according to an embodiment of the present disclosure;
Fig. 3 is a schematic view of a vertical height distribution of the surface of the substrate when the back coating layer is formed from aluminum nitride;
Fig. 4 is a schematic view of a vertical height distribution of the surface of the substrate when the back coating layer is formed from copper tungsten alloy; and
Fig. 5 is a cross sectional view of a LED chip according to an embodiment of the present disclosure.

### DETAILED DESCRIPTION

Reference will be made in detail to embodiments of the present disclosure. The same or similar elements and the elements having same or similar functions are denoted by like reference numerals throughout the descriptions.

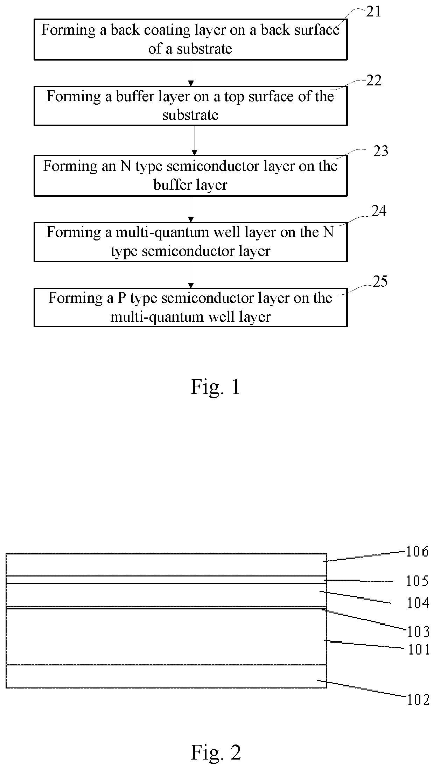

A method for manufacturing an epitaxial wafer for a light emitting diode (LED) is shown in Fig. 1. The epitaxial wafer may be manufactured in a MOCVD device, a molecular beam epitaxy (MBE) device or a hydride vapor phase epitaxy (HVPE) device. The high purity hydrogen and nitrogen are used as carrier gas, and the Ga source, the In source and the N source are the high purity trimethyl gallium, trimethyl indium and ammonia gas respectively. The method for manufacturing the epitaxial wafer for the light emitting diode comprises the steps of: 21) forming a back coating layer 102 on a back surface of a substrate 101; 22) forming a buffer layer 103 on a top surface of the substrate 101; 23) forming an N type semiconductor layer 104 on the buffer layer 103; 24) forming a multi-quantum well layer 105 on the N type semiconductor layer 104; and 25) forming a P type semiconductor layer 106 on the multi-quantum well layer 105.

The substrate is made from sapphire, SiC, GaN or silicon. The substrate has a thickness of 400 µm.

The back coating layer 102 has a thermal expansion coefficient less than that of the substrate 101. Moreover, the material of the back coating layer 102 does not react with the matter in the manufacturing device during manufacturing procedure. Furthermore, the material of the back coating layer 102 may not react with the metal organic sources, such as Ga, In, Si or Mg sources, hydrogen, nitrogen, and ammonia gas. In other words, there is no chemical reaction between the back coating layer 102 and substances in the manufacturing device during the epitaxial growth. In some embodiments, the back coating layer 102 is formed by physical vapor deposition (PVD), chemical vapor deposition (CVD), electroplating, printing or spin coating. The back coating layer 102 is made from aluminum nitride or a copper tungsten alloy.

The buffer layer is a non-crystal GaN layer grown at about 450°C-600°C through an epitaxial technology. The buffer layer may be a non-crystal GaN layer grown epitaxially at about 550°C through an epitaxial technology.

The N type semiconductor layer may be formed from III-V group compounds, such as GaN or GaAs, and then doped with an N type impurity. The N type semiconductor layer may be a GaN layer doped with silicon and is formed at about 950-1200°C. Especially, the N type semiconductor layer may be a GaN layer doped with silicon and is formed at about 1050°C. The silicon source may be SiH₄.

The multi-quantum well layer 105 may be an InGaN layer grown at about 750°C.

The P type semiconductor layer is formed from III-V group compounds, such as GaN or GaAs, and then doped with a P type impurity. The P type semiconductor layer may be a GaN layer doped with magnesium and is formed at about 950-1200°C. Especially, the P type semiconductor layer may be a GaN layer doped with magnesium and is formed at about 1050°C. The magnesium source may be Cp₂Mg.

According to an embodiment of the present disclosure, an epitaxial wafer is also provided, which will be described in the follows. Referring to Fig. 2, the epitaxial wafer comprises a substrate 101; a back coating layer 102 formed on a back surface of the substrate 101; a buffer layer 103 formed on a top surface of the substrate 101; an N type semiconductor layer 104 formed on the buffer layer 103; a multi-quantum well layer 105 formed on the N type semiconductor layer 104; and a P type semiconductor layer 106 formed on the multi-quantum well layer 105.

The substrate is made from sapphire, SiC, GaN or silicon. The substrate has a thickness of.

The thermal expansion coefficient of the material of the back coating layer 102 is less than that of the substrate 101. Furthermore, the material of the back coating layer 102 may not react with the metal organic sources such as Ga, In, Si or Mg sources, hydrogen, nitrogen, and ammonia gas. In other words, there is no chemical reaction between the back coating layer 102 and other substances in the manufacturing device during the manufacturing procedure. The material for the back coating layer 102 is aluminum nitride or a copper tungsten alloy.

The buffer layer is a non-crystal GaN layer. In some embodiments, the N type semiconductor layer is a layer formed from III-V group compounds, such as GaN or GaAs, and then doped with an N type impurity. The N type semiconductor layer may be a GaN layer doped with silicon. According to an embodiment of the present disclosure, the multi-quantum well layer 105 is an InGaN layer. The P type semiconductor layer may be a layer formed from III-V group compounds, such as GaN or GaAs, doped with a P type impurity. In a preferred embodiment, the P type semiconductor layer is a GaN layer doped with magnesium.

The thickness of the back coating layer is determined by the thermal expansion coefficient and an elastic modulus of the material of the back coating layer so as to obtain an epitaxial wafer with a uniform wavelength distribution. The back coating layer may have a thickness controlled within a certain range according to the thickness of the substrate to inhibit the warping of the substrate, thereby obtaining an epitaxial wafer with a uniform wavelength distribution.

According to a first embodiment of the present disclosure, the back coating layer is made from aluminum nitride (AlN), which has a thermal expansion coefficient of about 4.5e-6/K and an elastic modulus of about 270 GPa. When the substrate has a thickness of 400 µm and the AlN layer has a thickness of 0.27-0.31 µm, and when the temperature in the manufacturing device is about 750°C and there is a vertical temperature gradient distribution in the manufacturing device, the surface of the substrate may have a vertical height difference below 0.476 µm, so the emission wavelength fluctuation of the multi-quantum wall layer caused by the temperature, i.e., the emission wavelength difference between the center and the edges of the same epitaxial wafer, may be reduced to below about 1 nm. In some embodiments, the AlN layer has a thickness of about 0.27-0.30 µm. In some embodiments, the AlN layer has a thickness of preferably about 0.27-0.29 µm. In some embodiments, the AlN layer has a thickness of about 0.28 µm, 0.29 µm or 0.30 µm.

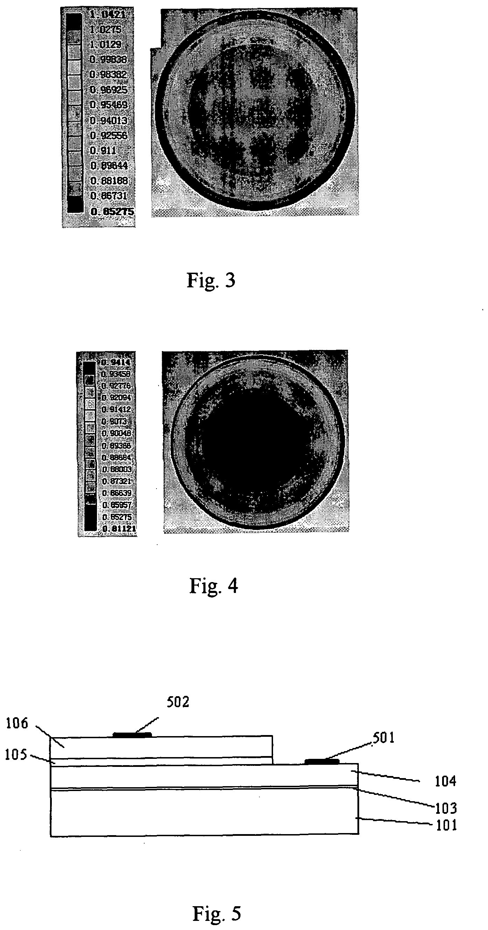

When the back coating layer made of AlN has a thickness of about 0.28 µm and the temperature in the manufacturing device is about 750°C with a vertical temperature gradient distribution therein, the substrate has a surface with a vertical height distribution shown in Fig. 3. The vertical height of the substrate becomes higher from the center to the edges of the substrate. The maximum height of the edges is about 1.0421 µm, and the vertical height of the center is about 0.85275 µm, so the vertical height difference is reduced to about 0.2 µm. Compared with the conventional epitaxial wafer without a back coating layer formed on the back surface of the substrate, the vertical height difference of the surface of the substrate is greatly reduced, so the emission wavelength difference between the center and the edges of the epitaxial wafer may be reduced correspondingly.

The back coating layer may be made from copper tungsten alloy, which comprises 10% copper and has a thermal expansion coefficient of about 5.7e-6/K and an elastic modulus of about 128 GPa. When the substrate has a thickness of 400 µm and the copper tungsten alloy layer has a thickness of 0.51-0.56 µm, and when the temperature in the manufacturing device is about 750°C and there is a vertical temperature gradient distribution in the manufacturing device, the surface of the substrate may have a vertical height difference less than about 0.476 µm, so the emission wavelength fluctuation of the multi-quantum wall layer caused by the temperature, i.e., the emission wavelength difference between the center and the edges of the same epitaxial wafer, may be reduced to less than 1 nm. In some embodiments, the copper tungsten alloy layer has a thickness of about 0.52-0.55 µm, or about 0.52-0.56 µm. In some embodiments, the copper tungsten alloy layer has a thickness of about 0.52 µm, 0.53 µm or 0.55 µm.

When the back coating layer made from AlN has a thickness of about 0.53 µm, the temperature in the manufacturing device is about 750°C and there is a vertical temperature gradient distribution in the manufacturing device, the substrate has a surface with a vertical height distribution shown in Fig. 4. The vertical height of the substrate becomes higher from the center to the edges of the substrate. The maximum height of the edges is about 0.9414 µm, and the vertical height of the center is about 0.81121 µm, so the vertical height difference is reduced to about 0.1 µm. Compared with the conventional epitaxial wafer without a back coating layer on the back surface of the substrate, the vertical height difference of the surface of the substrate is reduced greatly, so that the emission wavelength difference between the center and the edges of the epitaxial wafer may be reduced greatly.

As described above, during manufacturing of the epitaxial wafer, by forming a back coating layer on the back surface of the substrate which may inhibit the warping of the substrate, the vertical height difference of the substrate surface may be reduced, thereby increasing the uniformity of the emission wavelength of the epitaxial wafer.

In the following, a method for manufacturing a LED chip using the epitaxial wafer will be described in the following. The method for manufacturing the LED chip comprises the following steps: forming a back coating layer 102 on the back surface of a substrate 101; forming or growing a buffer layer 103 on the top surface of the substrate 101; forming or growing an N type semiconductor layer 104 on the buffer layer 103; forming or growing a multi-quantum well layer 105 on the N type semiconductor layer 104; forming or growing a P type semiconductor layer 106 on the multi-quantum well layer 105; etching a part of the P type semiconductor layer 106 and a corresponding part of the multi-quantum well layer 105 to expose a part of the N type semiconductor layer 104; forming an N type electrode 501 on the part of the N type semiconductor layer 104; forming a P type electrode 502 on the P type semiconductor layer 106; and thinning the back surface of the substrate 101 to remove the back coating layer 102 and a part of the substrate with a predetermined thickness.

After forming the N type and P type electrodes, the back surface of the substrate is thinned by grinding or polishing. Therefore, the back coating layer is just removed during the thinning of the back surface of the substrate. Then the subsequent manufacturing steps are the same as the conventional manufacturing steps, without using additional steps to treat the back coating layer. Therefore, the method for manufacturing the LED chip according to an embodiment of the present disclosure may be easy to realize whereas not reduce the output efficiency of the LED chip.

Referring to Fig. 5, the LED chip comprises: a substrate 101; a buffer layer 103 formed on the top surface of the substrate 101; an N type semiconductor layer 104 formed on the buffer layer 103; a multi-quantum well layer 105 formed on the N type semiconductor layer 104; a P type semiconductor layer 106 formed on the multi-quantum well layer 105; an N type electrode 501 formed on the N type semiconductor layer 104; and a P type electrode 502 formed on the P type semiconductor layer 106.

During the manufacturing of the LED chip as described hereinabove, a back coating layer is firstly formed on the back surface of the substrate 101, so the warping of the substrate 101 may be inhibited during the manufacturing thereof. And then the back coating layer is removed. Although the final structure of the LED chip of the present disclosure is similar to that of the conventional LED chip, the wavelength uniformity of the LED chip has been improved effectively. Therefore, even if the manufacturing device is bottom heated and there is a vertical temperature gradient distribution in the manufacturing device, the temperature difference of the surface of the epitaxial wafer may be reduced, thereby not influencing the uniformity of the emission wavelength of the LED chip accordingly.

According to the above embodiments of the present disclosure, a material with a thermal expansion coefficient less than that of the substrate is coated on the back surface of the substrate to balance the thermal expansion of the back surface of the substrate, so the warping of the substrate may be inhibited and the top surface of the substrate may be leveled, thereby increasing the uniformity of the emission wavelength of the epitaxial wafer.

## Claims

1. A method for manufacturing an epitaxial wafer for a light emitting diode (LED), comprising the steps of:
forming a back coating layer (102) on the back surface of a substrate (101) for balancing the thermal expansion of the back surface of the substrate (101), wherein (i) the back coating layer (102) is formed from aluminum nitride and has a thickness of 0.27 - 0.31µm or (ii) the back coating layer (102) is formed from a copper tungsten alloy and has a thickness of 0.51 - 0.56µm and the substrate (101) has a thickness of 400 µm and is formed of sapphire, SiC, GaN or silicon;
forming a buffer layer (103) on the top surface of the substrate (101);
forming an N type semiconductor layer (104) on the buffer layer (103);
forming a multi-quantum well layer (105) on the N type semiconductor layer (104); and
forming a P type semiconductor layer (106) on the multi-quantum well layer (105).

2. The method according to claim 1, wherein the back coating layer (102) is formed by physical vapor deposition (PVD), chemical vapor deposition (CVD), electroplating, printing or spin coating.

3. An epitaxial wafer for a light emitting diode, comprising:
a substrate (101) having a thickness of 400 µm, wherein the substrate (101) is formed of sapphire, SiC, GaN or silicon;
a back coating layer (102) formed on a back surface of the substrate (101) for balancing the thermal expansion of the back surface of the substrate (101), wherein (i) the back coating layer (102) is formed from aluminum nitride and has a thickness of 0.27 - 0.31µm or (ii) the back coating layer (102) is formed from a copper tungsten alloy and has a thickness of 0.51 - 0.56µm;
a buffer layer (103) formed on a top surface of the substrate (101);
an N type semiconductor layer (104) formed on the buffer layer (103);
a multi-quantum well layer (105) formed on the N type semiconductor layer (104); and
a P type semiconductor layer (106) formed on the multi-quantum well layer (105).

4. The epitaxial wafer according to claim 3, wherein the copper tungsten alloy comprises 10% copper.

5. The epitaxial wafer according to claim 3, wherein the substrate (101) is formed from sapphire.

6. A method for manufacturing a LED chip, comprising the steps of:
providing an epitaxial wafer according to one of claims 3-5;
etching a part of the P type semiconductor layer (106) and a corresponding part of the multi-quantum well layer (105) to expose a part of the N type semiconductor layer (104);
forming an N type electrode (501) on the part of the N type semiconductor layer (104);
forming a P type electrode (502) on the P type semiconductor layer (106); and
thinning the back surface of the substrate (101) to remove the back coating layer (102) and a part of the substrate (101) with a predetermined thickness.

## Patentansprüche

1. Verfahren zur Herstellung eines Epitaxialwafers für eine LED (Light Emitting Diode, LED), mit den folgenden Schritten:
Bilden einer Rückseitenbeschichtung (102) auf der Rückseite eines Substrats (101) zum Ausgleichen der Wärmeausdehnung der Rückseite des Substrats (101), wobei (i) die Rückseitenbeschichtung (102) aus Aluminiumnitrid gebildet wird und eine Dicke von 0,27 - 0,31 µm aufweist, oder (ii) die Rückseitenbeschichtung (102) aus einer Kupferwolframlegierung gebildet wird und eine Dicke von 0,51 - 0,56 µm aufweist, und das Substrat (101) eine Dicke von 400 µm aufweist und aus alpha-Aluminiumoxid, SiC, GaN oder Silizium gebildet wird;
Bilden einer Pufferschicht (103) auf der Oberseitedes Substrats (101);
Bilden einer n-Typ Halbleiterschicht (104) auf der Pufferschicht (103);
Bilden einer Multiquantentopfschicht (105) auf der n-Typ Halbleiterschicht (104); und
Formen einer p-Typ Halbleiterschicht (106) auf der Multiquantentopfschicht (105).

2. Verfahren nach Anspruch 1, wobei die Rückseitenbeschichtung (102) durch physikalische Dampfabscheidung (PVD), chemische Dampfabscheidung (Chemical Vapor Deposition, CVD), Elektroplattierung, Drucken oder Rotationsbeschichtung gebildet wird.

3. Epitaxialwafer für eine Leuchtdiode, aufweisend:
ein Substrat (101) mit einer Dicke von 400 µm, wobei das Substrat (101) aus alpha-Aluminiumoxid, SiC, GaN oder Silizium gebildet wird;
eine Rückseitenbeschichtung (102), die auf einer Rückseite des Substrats (101) gebildet ist, um die Wärmeausdehnung der Rückseite des Substrats (101) auszugleichen, wobei (i) die Rückseitenbeschichtung (102) aus Aluminiumnitrid gebildet ist und eine Dicke von 0,27 - 0,31 µm aufweist, oder (ii) die Rückseitenbeschichtung (102) aus einer Kupferwolframlegierung gebildet ist und eine Dicke von 0,51 - 0,56 µm aufweist;
eine Pufferschicht (103), die auf einer Oberseite des Substrats (101) gebildet ist;
eine n-Typ Halbleiterschicht (104), die auf der Pufferschicht (103) gebildet ist;
eine Multiquantentopfschicht (105), die auf der n-Typ Halbleiterschicht (104) gebildet ist; und
eine p-Typ Halbleiterschicht (106), die auf der Multiquantentopfschicht (105) gebildet ist.

4. Epitaxialwafer nach Anspruch 3, wobei die Kupferwolframlegierung 10% Kupfer enthält.

5. Epitaxialwafer nach Anspruch 3, wobei das Substrat (101) aus alpha-Aluminiumoxid gebildet ist.

6. Verfahren zur Herstellung eines LED-Chips, mit den folgenden Schritten:
Bereitstellen eines Epitaxialwafers nach einem der Ansprüche 3 - 5;
Ätzen eines Teils der p-Typ Halbleiterschicht (106) und eines entsprechenden Teils der Multiquantentopfschicht (105), um einen Teil der n-Typ Halbleiterschicht (104) freizulegen;
Bilden einer n-Typ Elektrode (501) auf dem Teil der n-Typ Halbleiterschicht (104);
Bilden einer p-Typ Elektrode (502) auf der p-Typ Halbleiterschicht (106); und
Verdünnen der Rückseite des Substrats (101), um die Rückseitenbeschichtung (102) und einen Teil des Substrats (101) mit einer vorbestimmten Dicke zu entfernen.

## Revendications

1. Procédé de fabrication d'une plaquette épitaxiale pour une diode électroluminescente (DEL), comprenant les étapes consistant à :
former une couche de revêtement arrière (102) sur la surface arrière d'un substrat (101) pour équilibrer l'expansion thermique de la surface arrière du substrat (101), dans lequel (i) la couche de revêtement arrière (102) est formée à partir de nitrure d'aluminium et a une épaisseur de 0,27-0,31 µm ou (ii) la couche de revêtement arrière (102) est formée d'un alliage de cuivre tungstène et a une épaisseur de 0,51-0,56 µm et le substrat (101) a une épaisseur de 400 µm et est formé de saphir, SiC, GaN ou silicium ;
former une couche tampon (103) sur la surface de sommet du substrat (101) ;
former une couche semi-conductrice de type N (104) sur la couche tampon (103) ;
former une couche de puits multi-quantique (105) sur la couche semi-conductrice de type N (104) ; et
former une couche semi-conductrice de type P (106) sur la couche de puits multi-quantique (105).

2. Procédé selon la revendication 1, dans lequel la couche de revêtement arrière (102) est formée par dépôt physique en phase vapeur (PVD), dépôt chimique en phase vapeur (CVD), galvanoplastie, impression ou enduction centrifuge.

3. Plaquette épitaxiale pour une diode électroluminescente, comprenant :
un substrat (101) ayant une épaisseur de 400 µm, dans lequel le substrat (101) est formé de saphir, SiC, GaN ou silicium ;
une couche de revêtement arrière (102) formée sur une surface arrière d'un substrat (101) pour équilibrer l'expansion thermique de la surface arrière du substrat (101), dans lequel (i) la couche de revêtement arrière (102) est formée à partir de nitrure d'aluminium et a une épaisseur de 0,27-0,31 µm ou (ii) la couche de revêtement arrière (102) est formée d'un alliage cuivre tungstène et a une épaisseur de 0,51-0,56 µm ;
une couche tampon (103) formée sur une surface de sommet du substrat (101) ;
une couche semi-conductrice de type N (104) formée sur la couche tampon (103) ;
une couche de puits multi-quantique (105) formée sur la couche semi-conductrice de type N (104) ; et
une couche semi-conductrice de type P (106) formée sur la couche de puis multi-quantique (105).

4. Plaquette épitaxiale selon la revendication 3, dans laquelle l'alliage cuivre tungstène comprend 10% de cuivre.

5. Plaquette épitaxiale selon la revendication 3, dans laquelle le substrat (101) est formé à partir de saphir.

6. Procédé de fabrication d'une puce à DEL, comprenant les étapes consistant à :
fournir une plaquette épitaxiale selon une des revendications 3-5 ;
attaquer chimiquement une partie de la couche semi-conductrice de type P (106) et une partie correspondante de la couche de puits multi-quantique (105) pour exposer une partie de la couche semi-conductrice de type N (104) ;
former une électrode de type N (501) sur la partie de la couche semi-conductrice de type N (104) ;
former une électrode de type P (502) sur la couche semi-conductrice de type P (106) ; et
amincir la surface arrière du substrat (101) afin d'éliminer la couche de revêtement arrière (102) et une partie du substrat (101) avec une épaisseur prédéterminée.
